# EUROPEAN PATENT APPLICATION

(11) **EP 4 354 504 A1**
(43) Date of publication of application: **17.04.2024**
(21) Application number: 23203377.9
(22) Date of filing: 13.10.2023
(51) Int. Cl.: H01L 27/15, H01L 33/46

(54) **TARGET LED CHIP WITH REFLECTIVE LAYER AND MANUFACTURING METHOD**

(30) Priority: 13.10.2022 CN 202211255427
(71) Applicant: Leyard Optoelectronic Co., Ltd, Beijing 100091 (CN)
(72) Inventor: YANG, Xiaoyu, Beijing (CN); MA, Li, Beijing (CN); LU, Changjun, Beijing (CN)
(74) Representative: EDP Patent Attorneys B.V.

(57) **Abstract**

Disclosed are a target LED chip with a reflective layer and a manufacturing method. The method comprises: providing a target substrate to a bottom of an initial LED chip, to obtain a first LED chip; depositing a first target liquid onto a top surface of the first LED chip to form a target protective layer, so as to obtain a second LED chip; etching the second LED chip, to obtain a third LED chip; treating the third LED chip according to a first target method to form reflective layers, so as to obtain a fourth LED chip; and removing top reflective layers, second side wall reflective layers and first sub-protective layers of the plurality of second LED sub-units, to obtain the target LED chip. The present invention solves the technical problem in the related art that the process of manufacturing side wall reflective layers of an LED chip is complex.

## Description

### Cross-Reference to Related Application

The present invention claims priority to Chinese Patent Application No. 202211255427.7, filed to the China National Intellectual Property Administration on October, 13, 2022 and entitled "Target LED Chip with Reflective Layer and Manufacturing Method", the disclosure of which is hereby incorporated by reference in its entirety.

### Technical Field

The present invention relates to the field of LED chips, and in particular, to a target LED chip with a reflective layer and a manufacturing method.

### Background

Currently, LED chips are applied more and more widely in production and life, and preventing light leakage on side walls of an LED chip, preventing optical crosstalk and increasing the photon utilization rate of the LED chip are essential consideration factors in a production process of the LED chip. However, in the related art, the photon utilization rate is mainly increased by manufacturing reflective layers; nevertheless, in the related art, the process of manufacturing side wall reflective layers of an LED chip is complex, and the reflective layers cannot completely cover the side walls of the LED chip. Therefore, how to manufacture side wall reflective layers of an LED chip via simple steps is a challenge faced at present.

In view of the described problems, no effective solution has been proposed.

### Summary

Embodiments of the present invention provide a target LED chip with a reflective layer and a manufacturing method, so as to at least solve the technical problem in the related art that the process of manufacturing side wall reflective layers of an LED chip is complex.

According to one aspect of embodiments of the present invention, provided is a target LED chip with a reflective layer, including: a target substrate and a plurality of target LED sub-units provided on the target substrate, wherein each of the target LED sub-units includes an initial LED sub-unit and a first side wall reflective layer, the first side wall reflective layer being a reflective layer which completely covers all surfaces except a bottom surface and a top surface of the initial LED sub-unit.

According to one aspect of embodiments of the present invention, provided is a manufacturing method for the target LED chip with the reflective layer, including: providing the target substrate to a bottom of an initial LED chip, to obtain a first LED chip; depositing a first target liquid onto a top surface of the first LED chip to form a target protective layer located on the top surface of the first LED chip, so as to obtain a second LED chip; etching the second LED chip from the target protective layer, and etching to a surface of the target substrate, so as to obtain a third LED chip including a plurality of first LED sub-units and the target substrate, wherein each first LED sub-unit of the plurality of first LED sub-units includes the initial LED sub-unit and a first sub-protective layer, the first sub-protective layer being a protective layer which is located on the top surface of each initial LED sub-unit of the plurality of first LED sub-units and obtained by etching the target protective layer; treating the third LED chip according to a first target method to form reflective layers respectively wrapped around all surfaces except bottom surfaces of the plurality of first LED sub-units, so as to obtain a fourth LED chip including a plurality of second LED sub-units and the target substrate, wherein each second LED sub-unit of the plurality of second LED sub-units includes the initial LED sub-unit, the first sub-protective layer and the reflective layer, the reflective layer including a top reflective layer, the first side wall reflective layer and a second side wall reflective layer, the top reflective layer is a reflective layer completely covering a top surface of the first sub-protective layer, the first side wall reflective layer is a reflective layer which completely covers all surfaces except the bottom surface and the top surface of the initial LED sub-unit, and the second side wall reflective layer is a reflective layer which completely covers all surfaces except a bottom surface and the top surface of the first sub-protective layer; and removing the top reflective layers, the second side wall reflective layers and the first sub-protective layers of the plurality of second LED sub-units, to obtain the target LED chip including the plurality of target LED sub-units and the target substrate, wherein each of the target LED sub-units includes the initial LED sub-unit and the first side wall reflective layer.

In some embodiments, a step of depositing the first target liquid onto the top surface of the first LED chip to form the target protective layer located on the top surface of the first LED chip, so as to obtain the second LED chip includes: mixing and stirring a first reagent and a second reagent at a predetermined ratio, to obtain an initial liquid; removing air bubbles in the initial liquid to obtain the first target liquid; and depositing the first target liquid onto the top surface of the first LED chip to form the target protective layer located on the top surface of the first LED chip, so as to obtain the second LED chip.

In some embodiments, the target protective layer includes at least one of: a cleanable colloid, a polymer material, an adhesive tape of a predetermined type, an organic material that can be removed by solution, and an inorganic material that can be removed by solution.

In some embodiments, a step of treating the third LED chip according to the first target method to form reflective layers respectively wrapped around all surfaces except the bottom surfaces of the plurality of first LED sub-units, so as to obtain the fourth LED chip including the plurality of second LED sub-units and the target substrate includes: when the first target method is a solution deposition method, immersing the third LED chip in a second target liquid to form the reflective layers respectively wrapped around all surfaces except the bottom surfaces of the plurality of first LED sub-units, so as to obtain the fourth LED chip including the plurality of second LED sub-units and the target substrate.

In some embodiments, a step of treating the third LED chip according to the first target method to form reflective layers respectively wrapped around all surfaces except the bottom surfaces of the plurality of first LED sub-units, so as to obtain the fourth LED chip including the plurality of second LED sub-units and the target substrate includes: when the first target method is an evaporation method, performing vapor deposition on the third LED chip to form the reflective layers respectively wrapped around all surfaces except the bottom surfaces of the plurality of first LED sub-units, so as to obtain the fourth LED chip including the plurality of second LED sub-units and the target substrate.

In some embodiments, the reflective layer includes at least one of: pure metal, semiconductor oxide, and ink.

In some embodiments, a step of removing the top reflective layers, the second side wall reflective layers and the first sub-protective layers of the plurality of second LED sub-units, to obtain the target LED chip including the plurality of target LED sub-units and the target substrate includes: determining a second target method according to a type of the first sub-protective layer; and removing, by using the second target method, the top reflective layers, the second side wall reflective layers and the first sub-protective layers of the plurality of second LED sub-units, to obtain the target LED chip including the plurality of target LED sub-units and the target substrate.

In some embodiments, a step of removing, by using the second target method, the top reflective layers, the second side wall reflective layers and the first sub-protective layers of the plurality of second LED sub-units, to obtain the target LED chip including the plurality of target LED sub-units and the target substrate includes: in the case that the first sub-protective layers of the plurality of second LED sub-units cannot be removed by using of the second target method, using a third target method to change shapes of the first sub-protective layers so as to obtain second sub-protective layers; and removing, by using the second target method, the top reflective layers, the second side wall reflective layers and the second sub-protective layers of the plurality of second LED sub-units, to obtain the target LED chip including the plurality of target LED sub-units and the target substrate.

In some embodiments, a step of etching the second LED chip from the target protective layer, and etching to the surface of the target substrate, so as to obtain the third LED chip including the plurality of first LED sub-units and the target substrate includes: etching the second LED chip by using an inductively coupled plasma etching method, and etching to the surface of the target substrate, so as to obtain the third LED chip including the plurality of first LED sub-units and the target substrate.

In embodiments of the present invention, by providing the target substrate to the bottom of the initial LED chip, to obtain the first LED chip; depositing the first target liquid onto the top surface of the first LED chip to form the target protective layer located on the top surface of the first LED chip, so as to obtain the second LED chip; etching the second LED chip from the target protective layer, and etching to the surface of the target substrate, so as to obtain the third LED chip including the plurality of first LED sub-units and the target substrate, wherein each first LED sub-unit of the plurality of first LED sub-units includes the initial LED sub-unit and the first sub-protective layer, the first sub-protective layer being the protective layer which is located on the top surface of each initial LED sub-unit of the plurality of first LED sub-units and obtained by etching the target protective layer; treating the third LED chip according to the first target method to form reflective layers respectively wrapped around all surfaces except the bottom surfaces of the plurality of first LED sub-units, so as to obtain the fourth LED chip including the plurality of second LED sub-units and the target substrate, wherein each second LED sub-unit of the plurality of second LED sub-units includes the initial LED sub-unit, the first sub-protective layer and the reflective layer, the reflective layer including the top reflective layer, the first side wall reflective layer and the second side wall reflective layer, the top reflective layer is the reflective layer completely covering the top surface of the first sub-protective layer, the first side wall reflective layer is the reflective layer which completely covers all surfaces except the bottom surface and the top surface of the initial LED sub-unit, and the second side wall reflective layer is the reflective layer which completely covers all surfaces except the bottom surface and the top surface of the first sub-protective layer; and removing the top reflective layers, the second side wall reflective layers and the first sub-protective layers of the plurality of second LED sub-units, to obtain the target LED chip including the plurality of target LED sub-units and the target substrate, wherein each of the target LED sub-units includes the initial LED sub-unit and the first side wall reflective layer. The protective layer is manufactured on the top surface of the LED chip, and thus when the top reflective layers, the second side wall reflective layers and the first sub-protective layers are removed, the top surfaces of the plurality of initial LED sub-units will not be damaged; as the first side wall reflective layers of the finally manufactured LED chip completely cover all surfaces except the bottom surfaces and the top surfaces of the plurality of initial LED sub-units, the photon utilization rate can be greatly increased, light leakage on side walls of the plurality of target LED sub-units and optical crosstalk between the plurality of target LED sub-units are avoided; furthermore, the side wall reflective layers of the LED chip can be manufactured via simple steps, thereby solving the technical problem in the related art that the process of manufacturing side wall reflective layers of the LED chip is complex.

### Brief Description of the Drawings

The drawings illustrated herein are used for providing further understanding of the present invention, constitute a part of the present invention; and illustrative embodiments of the present invention and illustrations thereof are used for explaining the present invention, rather than constitute inappropriate limitations on the present invention. In the drawings:
Fig. 1 is a schematic diagram of a target LED chip with a reflective layer according to embodiments of the present invention;
Fig. 2 is a flowchart of a manufacturing method for the target LED chip with the reflective layer according to embodiments of the present invention;
Fig. 3 is a schematic diagram of a manufacturing process of the target LED chip with the reflective layer provided according to optional embodiments of the present invention; and
Fig. 4 is a schematic diagram showing comparison of a light regulating effect, in a color conversion light-emitting chip, of reflective layers of the target LED chip with the reflective layer provided according to optional embodiments of the present invention.

### Detailed Description of the Embodiments

Hereinafter, in order to make a person skilled in the art better understand the solutions of the present invention, the technical solutions in the embodiments of the present invention are described clearly and completely with reference to the drawings in the embodiments of the present invention. Obviously, the embodiments as described are only parts of embodiments rather than all the embodiments of the present invention. All other embodiments obtained by a person of ordinary skill in the art on the basis of the embodiments of the present invention without any inventive effort shall all fall within the scope of protection of the present invention.

It should be noted that the terms "first", "second" etc., in the description, claims, and accompanying drawings of the present invention are used to distinguish similar objects, and are not necessarily used to describe a specific sequence or precedence order. It should be understood that the data so used may be interchanged where appropriate so that the embodiments of the present invention described herein can be implemented in sequences other than those illustrated or described herein. In addition, the terms "include" and "have", and any variations thereof are intended to cover a non-exclusive inclusion, for example, a process, method, system, product, or device that includes a series of steps or units is not necessarily limited to those steps or units that are clearly listed, but may include other steps or units that are not clearly listed or inherent to such process, method, product, or device.

### Embodiment 1

According to embodiments of the present invention, an embodiment of a target LED chip with a reflective layer is provided.

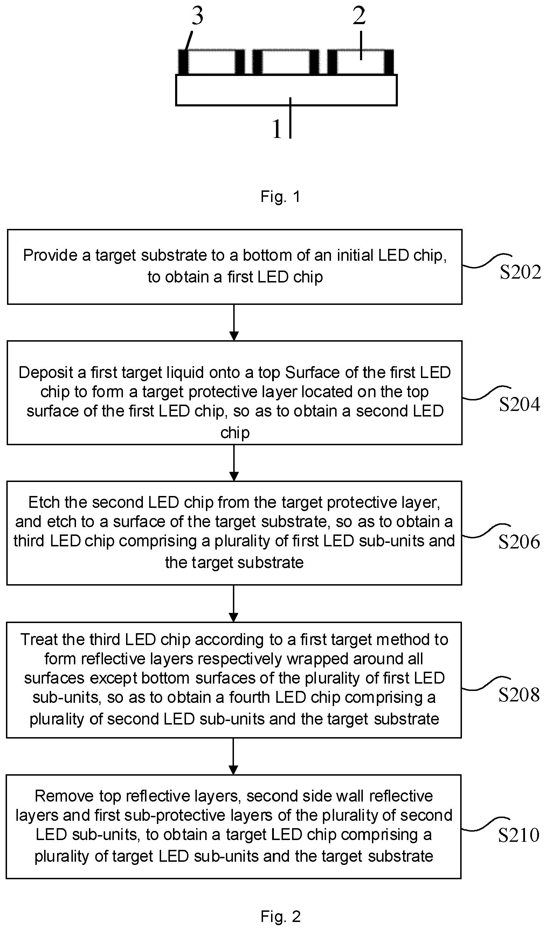

Fig. 1 is a schematic diagram of the target LED chip with the reflective layer according to the embodiment of the present invention. In Fig. 1: 1. Target substrate; 2. Initial LED sub-unit; 3. First side wall reflective layer. As shown in Fig. 1, the target LED sub-unit includes the initial LED sub-unit 2 and the first side wall reflective layer 3; the target substrate is provided with three target LED sub-units, and all surfaces except a bottom surface and a top surface of each initial LED sub-unit are covered by the first side wall reflective layer.

As some optional embodiments, a target LED chip with a reflective layer is provided, including: a target substrate and a plurality of target LED sub-units provided on the target substrate, wherein each of the target LED sub-units includes an initial LED sub-unit and a first side wall reflective layer, the first side wall reflective layer being a reflective layer which completely covers all surfaces except a bottom surface and a top surface of the initial LED sub-unit. Since the first side wall reflective layer completely covers all surfaces except the bottom surface and the top surface of the initial LED sub-unit, the photon utilization rate can be greatly increased, and light leakage on side walls of the LED chip and optical crosstalk between the target LED sub-units can be avoided. "LED" is an abbreviation of Light-Emitting Diode.

### Embodiment 2

According to embodiments of the present invention, an embodiment of a manufacturing method for the target LED chip with the reflective layer is provided. It should be noted that the steps illustrated in the flowchart of the drawings can be executed in a computer system such as a set of computer-executable instructions, and although a logical order is shown in the flowchart, in some cases, the steps shown or described can be executed in a different order from that described herein.

Fig. 2 is a flowchart of the manufacturing method for the target LED chip with the reflective layer according to embodiments of the present invention. As shown in Fig. 2, the manufacturing method includes the following steps:
step S202, providing the target substrate to a bottom of an initial LED chip, to obtain a first LED chip;
step S204, depositing a first target liquid onto a top surface of the first LED chip to form a target protective layer located on the top surface of the first LED chip, so as to obtain a second LED chip;
step S206, etching the second LED chip from the target protective layer, and etching to a surface of the target substrate, so as to obtain a third LED chip including a plurality of first LED sub-units and the target substrate;
step S208, treating the third LED chip according to a first target method to form reflective layers respectively wrapped around all surfaces except bottom surfaces of the plurality of first LED sub-units, so as to obtain a fourth LED chip including a plurality of second LED sub-units and the target substrate; and
step S210, removing top reflective layers, second side wall reflective layers and first sub-protective layers of the plurality of second LED sub-units, to obtain the target LED chip including the plurality of target LED sub-units and the target substrate.

In the steps above, by providing the target substrate to the bottom of the initial LED chip, to obtain the first LED chip; depositing the first target liquid onto the top surface of the first LED chip to form the target protective layer located on the top surface of the first LED chip, so as to obtain the second LED chip; etching the second LED chip from the target protective layer, and etching to the surface of the target substrate, so as to obtain the third LED chip including the plurality of first LED sub-units and the target substrate, wherein each first LED sub-unit of the plurality of first LED sub-units includes the initial LED sub-unit and the first sub-protective layer, the first sub-protective layer being a protective layer which is located on a top surface of each initial LED sub-unit of the plurality of first LED sub-units and obtained by etching the target protective layer; treating the third LED chip according to the first target method to form reflective layers respectively wrapped around all surfaces except the bottom surfaces of the plurality of first LED sub-units, so as to obtain the fourth LED chip including the plurality of second LED sub-units and the target substrate, wherein each second LED sub-unit of the plurality of second LED sub-units includes the initial LED sub-unit, the first sub-protective layer and the reflective layer, the reflective layer including the top reflective layer, the first side wall reflective layer and the second side wall reflective layer, the top reflective layer is a reflective layer completely covering a top surface of the first sub-protective layer, the first side wall reflective layer is a reflective layer which completely covers all surfaces except the bottom surface and the top surface of the initial LED sub-unit, and the second side wall reflective layer is a reflective layer which completely covers all surfaces except a bottom surface and the top surface of the first sub-protective layer; and removing the top reflective layers, the second side wall reflective layers and the first sub-protective layers of the plurality of second LED sub-units, to obtain the target LED chip including the plurality of target LED sub-units and the target substrate, wherein each of the target LED sub-units includes the initial LED sub-unit and the first side wall reflective layer; the top surface of each of the plurality of first LED sub-units includes a first sub-protective layer, and the first sub-protective layer is the protective layer which is located on the top surface of each first LED sub-unit of the plurality of first LED sub-units and obtained by etching the target protective layer; treating the third LED chip according to the first target method to form the reflective layers respectively wrapped around all surfaces except the bottom surfaces of the plurality of first LED sub-units, so as to obtain the fourth LED chip including the plurality of second LED sub-units and the target substrate, wherein the reflective layer include the top reflective layer; and removing the top reflective layers and the first sub-protective layers located on the top surfaces of the plurality of second LED sub-units, so as to obtain the target LED chip including the plurality of target LED sub-units and the target substrate.

The protective layer is manufactured on the top surface of the LED chip, and thus when the top reflective layers, the second side wall reflective layers and the first sub-protective layers are removed, the top surfaces of the plurality of target initial LED sub-units will not be damaged; as the first side wall reflective layers of the finally manufactured LED chip completely cover all surfaces except the bottom surfaces and the top surfaces of the plurality of initial LED sub-units, the photon utilization rate can be greatly increased, light leakage on side walls of the plurality of target LED sub-units and optical crosstalk between the plurality of target LED sub-units are avoided; furthermore, the side wall reflective layers of the LED chip can be manufactured via simple steps, thereby solving the technical problem in the related art that the process of manufacturing side wall reflective layers of the LED chip is complex.

First of all, it should be noted that the present invention innovatively employs a process technology of "top surface protection + side wall modification", and the technical process is completely compatible with a pre-manufacturing process of a chip. The method is simple and flexible and has high repeatability, can effectively avoid light leakage on side walls, increase the photon utilization rate, and can even passivate a side wall defect of the chip. The method has universality, and is applicable to solving various problems related to chip side walls. Some embodiments of the present invention will be introduced in detail below.

As some optional embodiments, the target substrate is provided to the bottom of the initial LED chip, to obtain the first LED chip, and the first target liquid is deposited onto the top surface of the first LED chip to form the target protective layer located on the top surface of the first LED chip, so as to obtain the second LED chip. The protective layer is manufactured on the top surface of the LED chip, and thus when the top reflective layers and the first sub-protective layers are removed, the top surface of the LED chip will not be damaged.

It should be noted that the target substrate includes an epitaxial chip; in some embodiments of the present invention, the etched LED chip has a size range of 1 micron - 200 microns; the light-emitting wavelength range of the chip is a visible light range (300 nanometers - 1000 nanometers); and a Mini/Micro-LED epitaxial chip is a light-emitting device based on a Group III-V semiconductor light-emitting layer, and includes a p-type injection layer, a light-emitting layer, an n-type injection layer and an electrode. Group III-V semiconductor material includes one or more of, but is not limited to, gallium nitride GaN, gallium arsenide GaAs, indium gallium nitride InGaN, aluminum gallium indium phosphide AIGalnP, and the like.

As some optional embodiments, a method for manufacturing the target protective layer includes: mixing and stirring a first reagent and a second reagent at a predetermined ratio, to obtain an initial liquid; removing air bubbles in the initial liquid to obtain the first target liquid; and depositing the first target liquid onto the top surface of the first LED chip to form the target protective layer located on the top surface of the first LED chip, so as to obtain the second LED chip. In this manner, the target protective layer on the top surface of the LED chip can be quickly manufactured, to protect the top surface of the LED chip; for example, the predetermined ratio is that the mass ratio of the first reagent to the second reagent is 10:1, and the first reagent is a conventional polydimethylsiloxane PDMS reagent, and the second reagent is a curing agent; and the conventional PDMS reagent and the curing agent are mixed at the mass ratio of 10:1 and stirred for 10 min to form a PDMS prepolymer (i.e. the initial liquid), and then air bubbles generated during stirring are removed from the PDMS prepolymer by vacuum extraction. The bubble-free PDMS prepolymer (i.e. the first target liquid) is deposited onto the top surface of the first LED chip via a spin-coating method by using parameters of 1000 revolutions per minute and 60 seconds; then the first LED chip coated with PDMS is placed in an oven and cured at 75 degrees for 3 hours, and is taken out to stand to room temperature to complete the preparation of the PDMS top protective layer, so as to obtain the second LED chip. In this way, since the preparation of the PDMS top protective layer can be completed by taking out the first LED chip to stand to room temperature, the target protective layer can be manufactured quickly.

It should be noted that, the coating method of the target protective layer includes, but is not limited to, a spin-coating method, a blade coating method, a screen printing method, an imprint transfer method, a spray coating method, and the like. The material of the target protective layer includes at least one of: a cleanable colloid, a polymer material, an adhesive tape of a predetermined type, an organic material that can be removed by solution, and an inorganic material that can be removed by solution. For example, the target protective layer may be selected from common colloid such as photoresist and hot melt adhesive allowing for cleaning by post-treatment, or common polymer materials such as polymethyl methacrylate PMMA and polydimethylsiloxane PDMS, or common adhesive tapes such as conductive carbon adhesive, non-residue polyimide adhesive tape, high-temperature adhesive tape which can be directly attached, or other organic or inorganic materials that can be removed by solution. The thickness range of the target protective layer can also be set to be 1 micro to 500 microns. By providing the protective layer, a whole layer of thick top protective layer can be coated on the chip structure which has grown epitaxially but has not been etched/cut, so as to avoid subsequent accidental growth of the reflective layer or defect introduction on the top surface.

As some optional embodiments, etching the second LED chip from the target protective layer, and etching to the surface of the target substrate, so as to obtain the third LED chip including the plurality of first LED sub-units and the target substrate, wherein each first LED sub-unit of the plurality of first LED sub-units includes the initial LED sub-unit and the first sub-protective layer, the first sub-protective layer being the protective layer which is located on the top surface of each initial LED sub-unit of the plurality of first LED sub-units and obtained by etching the target protective layer. Etching the second LED chip can quickly obtain the plurality of first LED sub-units, and then further obtain the third LED chip including the plurality of first LED sub-units and the target substrate. The entire epitaxial chip structure can form micron-sized chip units according to a conventional chip etching/cutting process, so as to expose four side walls of each chip unit, so as to ensure that the reflective layers can be subsequently grown on the other four walls except the top surface covered by the protective layer.

As some optional embodiments, a method for etching the second LED chip includes: etching the second LED chip by using an ICP (inductively coupled plasma) etching method, and etching to the surface of the target substrate, so as to obtain the third LED chip including the plurality of first LED sub-units and the target substrate. By the ICP etching method, a face-up chip can be divided into a plurality of independent Micro-LED chip units of a size of 50 microns, and a downward etching depth at least needs to include a multi-quantum well light-emitting structure; and after etching, peripheral side walls of each chip unit are exposed, and the protective layer is provided on the top surface of the chip for protection, so that the third LED chip can be obtained simply.

It should be noted that the third LED chip can be obtained by an etching or cutting manner, and the selection of the etching manner or the cutting manner is mainly depending on whether the protective layer can withstand the etching process, that is, whether using the etching manner or the cutting manner, it is necessary to ensure that large-area shape change, and/or damage do not occur to the protective layer.

As some optional embodiments, treating the third LED chip according to the first target method to form reflective layers respectively wrapped around all surfaces except the bottom surfaces of the plurality of first LED sub-units, so as to obtain the fourth LED chip including the plurality of second LED sub-units and the target substrate, wherein each second LED sub-unit of the plurality of second LED sub-units includes the initial LED sub-unit, the first sub-protective layer and the reflective layer, the reflective layer including the top reflective layer, the first side wall reflective layer and the second side wall reflective layer, the top reflective layer is a reflective layer completely covering the top surface of the first sub-protective layer, the first side wall reflective layer is a reflective layer which completely covers all surfaces except the bottom surface and the top surface of the initial LED sub-unit, and the second side wall reflective layer is a reflective layer which completely covers all surfaces except the bottom surface and the top surface of the first sub-protective layer. There are a plurality of first target methods, for example, the first target method may be a solution deposition method, and may also be an evaporation method. By the first target method, the reflective layers can be manufactured, the photon utilization rate can be greatly increased, and light leakage on side walls of the LED chip and optical crosstalk between the target LED sub-units can be avoided.

It should be noted that the reflective layer includes at least one of: pure metal, semiconductor oxide, and ink. For example, when the reflective layer is of pure metal, the reflective layer includes one or more metals, such as common metal materials for visible light reflection, e.g. silver Ag, aluminum Al. If pure metal reflective layer is used, a transparent insulation layer needs to be additionally constructed to isolate the chip from conductive metal, and the adopted transparent insulation material includes, but is not limited to, aluminum oxide Al₂O₃, titanium dioxide TiO₂, silicon dioxide SiO₂, aluminum nitride AINx, etc.; wherein the insulation material should be selected as a material with a strong adhesive force to both the chip and the metal. In particular, the material of the insulation layer may use a construction method without affecting the target protective layer, such as a solution method, and a vapor phase method, or the like. When the reflective layer is of a semiconductor oxide, the reflective layer is of common semiconductor oxide material for constructing a distributed Bragg DBR reflective layer, including, but not limited to, one or more of materials such as titanium oxide TiOx and aluminum oxide AlOx, and the number and material selection of the DBR layers will be determined according to the emission wavelength of the chip. When the reflective layer is of an ink, the reflective layer is of common ink materials for display electronics, including, but not limited to, various colors and various types of inks such as black and white, and the ink can perform visible light reflection well and has the capability of being adhered to the side walls of the LED chip.

As some optional embodiments, when the first target method is the solution deposition method, immersing the third LED chip in a second target liquid to form the reflective layers respectively wrapped around all surfaces except the bottom surfaces of the plurality of first LED sub-units, so as to obtain the fourth LED chip including the plurality of second LED sub-units and the target substrate. For example, the third LED chip is immersed into a reflective layer precursor solution, and then a method such as a hydrothermal growth method, an electrochemical reduction method, and an electroless plating method is used to form the reflective layers respectively wrapped around all surfaces except the bottom surfaces of the plurality of first LED sub-units. The solution deposition method has the advantages of low cost and low energy consumption, and basically has no damage to the LED chip, and the method has high flexibility and high repeatability.

As some optional embodiments, when the first target method is the evaporation method, vapor deposition is performed on the third LED chip; for example, the third LED chip is placed obliquely at a certain angle, and the third LED chip is continuously rotated during the evaporation, to ensure that the reflective layer material is deposited on all surfaces except the bottom surfaces to form the reflective layers respectively wrapped around all surfaces except the bottom surfaces of the plurality of first LED sub-units, and the thickness of the reflective layer is usually 10 nanometers - 50 microns, to obtain the fourth LED chip including the plurality of second LED sub-units and the target substrate. The evaporation method can make the reflective layer more uniform, prevent pin holes from appearing, and can control the thickness of the reflective layer more flexibly.

As some optional embodiments, removing the top reflective layers, the second side wall reflective layers and the first sub-protective layers of the plurality of second LED sub-units, to obtain the target LED chip including the plurality of target LED sub-units and the target substrate, wherein each of the target LED sub-units includes the initial LED sub-unit and the first side wall reflective layer. A method for removing the top reflective layers, the second side wall reflective layers and the first sub-protective layers includes: determining a second target method according to the type of the first sub-protective layer, wherein the second target method includes but is not limited to a flushing method, a heating softening method, an immersion dissolving method, an illumination cleaning method, a mechanical stripping method, etc.; and removing, by using the second target method, the top reflective layers, the second side wall reflective layers and the first sub-protective layers of the plurality of second LED sub-units, to obtain the target LED chip including the plurality of target LED sub-units and the target substrate. According to the type of the first sub-protective layer, the determined second target method can better remove the top reflective layers, the second side wall reflective layers and the first sub-protective layers, and better protect the top surfaces of the plurality of initial LED sub-units.

It should be noted that the second target method can be used to directly remove the first sub-protective layers located on the top surfaces of the plurality of initial LED sub-units, and in the case that the first sub-protective layers are removed, the top reflective layers located on the top surfaces of the plurality of first sub-protective layers and the second reflective layers which completely cover all surfaces except the bottom surfaces and the top surfaces of the plurality of first sub-protective layers will automatically disappear; in this way, the target LED chip including the plurality of target LED sub-units and the target substrate can be obtained, and thus the production flow is simplified, and the production cost is reduced.

As some optional embodiments, in the case that the first sub-protective layers of the plurality of second LED sub-units cannot be removed by using the second target method, using a third target method to change shapes of the first sub-protective layers so as to obtain second sub-protective layers, for example, if the reflective layer material is very dense and the top reflective layers completely wrap the first sub-protective layers, then the first sub-protective layers cannot be removed by the second target method, and therefore, the shapes of the first sub-protective layers can be changed by ultrasonic, mechanical, photo-thermal and the like, so that the first sub-protective layers are exposed from the top reflective layers, thereby allowing for removal of the first sub-protective layers more easily; and removing, by using the second target method, the top reflective layers, the second side wall reflective layers and the second sub-protective layers of the plurality of second LED sub-units, to obtain the target LED chip including the plurality of target LED sub-units and the target substrate. In this way, the situation that the second target method cannot remove the first sub-protective layers of the plurality of second LED sub-units can be handled more conveniently.

It should be noted that the side walls may be processed targetedly through the manner above, so that all surfaces except the bottom surface and the top surface of each target LED sub-unit have corresponding functions, and have strong function extensibility.

On the basis of the described content, the present invention provides an optional embodiment, and the optional embodiment is introduced below:
optional embodiments of the present invention provide a target LED chip with a reflective layer and a method for manufacturing side wall reflective layers of the LED chip; with regard to the relevant technical problem of side walls of conventional Mini/Micro-LED chip, the present invention innovatively employs a process technology of "top surface protection + side wall modification"; and aiming at the specific difficulties such as light leakage on side walls of the chip and a low photon utilization rate, a full-top emission chip in which the surrounding four walls are coated with reflective layers and the top surface has no shielding is constructed, and the target LED chip with the reflective layer can be manufactured quickly with low energy consumption. Hereinafter, optional embodiments of the present invention will be introduced in detail:

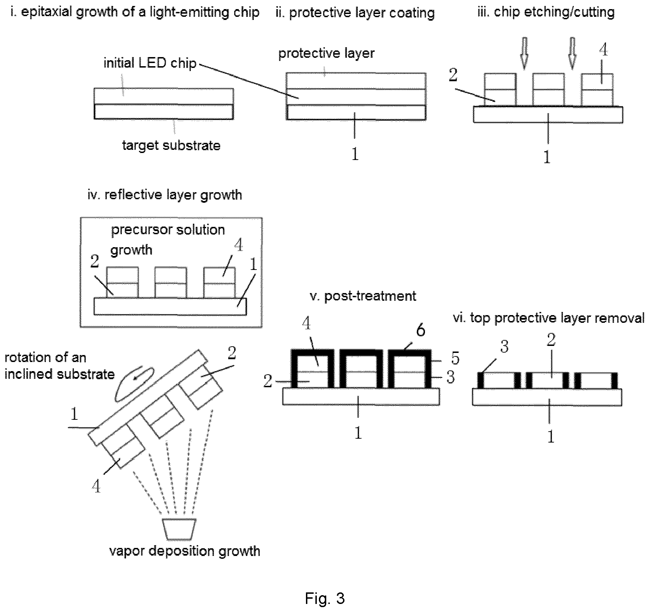

Fig. 3 is a schematic diagram of a manufacturing process for the target LED chip with the reflective layer provided according to optional embodiments of the present invention. The reference numerals in Fig. 3 follow the reference numerals in Fig. 1: 1. Target substrate; 2. Initial LED sub-unit; 3. First side wall reflective layer; 4. First sub-protective layer; 5. Second side wall reflective layer; 6. Top reflective layer; the target substrate and the initial LED chip in i form a first LED chip; the target substrate 1, the initial LED chip and a protective layer in ii form a second LED chip; the target substrate 1, the initial LED sub-units 2 and the first sub-protective layers 4 in iii and iv form a third LED chip; the initial LED sub-units 2 and the first sub-protective layers 4 in iii and iv form first LED sub-units; the target substrate 1, the initial LED sub-units 2, the first side wall reflective layers 3, the first sub-protective layers 4, the second side wall reflective layers 5 and the top reflective layers 6 in v form a fourth LED chip; the initial LED sub-units 2, the first side wall reflective layers 3, the first sub-protective layers 4, the second side wall reflective layers 5 and the top reflective layers 6 in v form second LED sub-units; the target substrate 1, the initial LED sub-units 2 and the first side wall reflective layers 3 in vi form the target LED chip; and the initial LED sub-units 2 and the first side wall reflective layers 3 in vi form target LED sub-units. As shown in Fig. 3, i. epitaxial growth of a light-emitting chip, which is providing the target substrate to the bottom of the initial LED chip, to obtain the first LED chip as stated above; ii. protective layer coating, which is depositing the first target liquid onto the top surface of the first LED chip to form the target protective layer located on the top surface of the first LED chip, so as to obtain the second LED chip as stated above; iii. chip etching/cutting, which is etching the second LED chip from the target protective layer, and etching to the surface of the target substrate, so as to obtain the third LED chip including the plurality of first LED sub-units and the target substrate as stated above; iv. reflective layer growth and v. post-treatment, which are treating the third LED chip according to the first target method to form reflective layers respectively wrapped around all surfaces except the bottom surfaces of the plurality of first LED sub-units, so as to obtain the fourth LED chip including the plurality of second LED sub-units and the target substrate as stated above, wherein in iv, precursor solution growth is the solution deposition method as stated above, and vapor deposition is the evaporation method as stated above; and vi. top protective layer removal, which is removing the top reflective layers, the second side wall reflective layers and the first sub-protective layers of the plurality of second LED sub-units, to obtain the target LED chip including the plurality of target LED sub-units and the target substrate as stated above.

Generally speaking, in the present optional embodiment, a whole layer of thick top protective layer is coated on the chip structure which has grown epitaxially but has not been etched/cut, so as to avoid subsequent accidental growth of the reflective layer or defect introduction on the top surface. Next, the entire epitaxial chip structure forms micron-sized chip units according to a conventional chip etching/cutting process, so as to expose four side walls of each chip unit. Then, the whole wafer carrying a large number of micron-sized chip units can be selected to be immersed into a solution containing a reflective layer precursor for growth, so as to ensure that the other four walls except the top walls covered by the protective layer are all in contact with the solution, and thus the reflective layers can be grown; and a vapor deposition method may also be selected to grow and deposit the reflective layers on all the side walls, and the specific method is: placing the wafer obliquely at a certain angle, and continuously rotating the substrate in the evaporation process, so as to ensure that the reflective layer material is deposited on all the side walls. Finally, the top protective layer is removed, to obtain a full-top emission light-emitting chip with the reflective layers on the side walls.

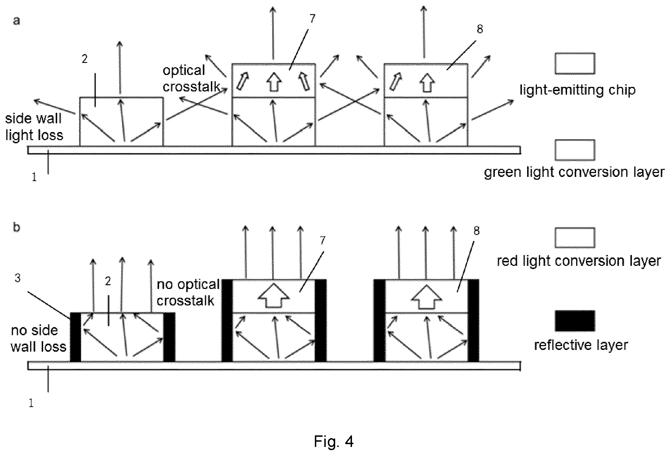

Fig. 4 is a schematic diagram showing comparison of a light regulating effect, in a color conversion light-emitting chip, of reflective layers of the target LED chip with the reflective layer provided according to optional embodiments of the present invention. The reference numerals in Fig. 4 follow the reference numerals in Fig. 1: 1. Target substrate; 2. Initial LED sub-unit; 3. First side wall reflective layer. 7. Green light conversion layer; 8. Red light conversion layer. As shown in Fig. 4, a is the situation in which there is no side wall reflective layer, in this case, side wall light loss and optical crosstalk between a plurality of first LED sub-units may occur; and b is the situation in which all surfaces except the bottom surfaces and the top surfaces of the LED sub-units are completely covered by reflective layers, that is, the LED sub-units include side wall reflective layers, and in this case, there is neither side wall light loss nor optical crosstalk.

By the optional embodiments above, at least the following beneficial effects can be achieved:
(1) side wall reflective layers are fully coated, full coating of the side wall reflective layers is achieved by a solution or vapor phase method without affecting light exiting at the top surface, greatly reducing the situation of light leakage on side walls of the light-emitting chip, increasing the photon utilization rate, and preventing crosstalk excitation that may occur in a quantum dot color conversion chip;
(2) the process during manufacturing is simple, the manufacturing process is compatible with the existing chip manufacturing process, and reflective layers on four walls for preventing light leakage on the side walls can be losslessly constructed by using a simple solution method; and
(3) the cost is lower compared with methods such as vapor phase etching used in conventional processes.

It should be noted that for brevity of description, the method embodiments above are described as a series of action combinations. However, a person skilled in the art should understand that some embodiments of the present invention are not limited to the described sequence of actions, because according to some embodiments of the present invention, some steps may be performed in other sequences or performed simultaneously. Secondly, a person skilled in the art should also know that the embodiments described in the description are all preferred embodiments, and the involved actions and modules are not necessarily required in some embodiments of the present invention.

In the embodiments of the present invention, the description of each embodiment has its own emphasis. For the part not detailed in a certain embodiment, please refer to the relevant description in other embodiments.

In the several embodiments provided in the present invention, it should be understood that the disclosed technical content may be implemented in other manners. The apparatus embodiments as described above are merely exemplary.

The contents above are only the preferred embodiments of the present invention. It should be pointed out that for a person of ordinary skill in the technical field, several improvements and refinements can be made without departing from the principle of the present invention, and these improvements and refinements shall also fall within the scope of protection of the present invention.

## Claims

1. A target LED chip with a reflective layer, comprising: a target substrate and a plurality of target LED sub-units provided on the target substrate, wherein each of the target LED sub-units comprises an initial LED sub-unit and a first side wall reflective layer, the first side wall reflective layer being a reflective layer which completely covers all surfaces except a bottom surface and a top surface of the initial LED sub-unit.

2. A manufacturing method for the target LED chip with the reflective layer according to claim 1, comprising:
providing the target substrate to a bottom of an initial LED chip, to obtain a first LED chip;
depositing a first target liquid onto a top surface of the first LED chip to form a target protective layer located on the top surface of the first LED chip, so as to obtain a second LED chip;
etching the second LED chip from the target protective layer, and etching to a surface of the target substrate, so as to obtain a third LED chip comprising a plurality of first LED sub-units and the target substrate, wherein each first LED sub-unit of the plurality of first LED sub-units comprises the initial LED sub-unit and a first sub-protective layer, the first sub-protective layer being a protective layer which is located on the top surface of each initial LED sub-unit of the plurality of first LED sub-units and obtained by etching the target protective layer;
treating the third LED chip according to a first target method to form reflective layers respectively wrapped around all surfaces except bottom surfaces of the plurality of first LED sub-units, so as to obtain a fourth LED chip comprising a plurality of second LED sub-units and the target substrate, wherein each second LED sub-unit of the plurality of second LED sub-units comprises the initial LED sub-unit, the first sub-protective layer and the reflective layer, the reflective layer comprising a top reflective layer, the first side wall reflective layer and a second side wall reflective layer, the top reflective layer is a reflective layer completely covering a top surface of the first sub-protective layer, the first side wall reflective layer is a reflective layer which completely covers all surfaces except the bottom surface and the top surface of the initial LED sub-unit, and the second side wall reflective layer is a reflective layer which completely covers all surfaces except a bottom surface and the top surface of the first sub-protective layer; and
removing the top reflective layers, the second side wall reflective layers and the first sub-protective layers of the plurality of second LED sub-units, to obtain the target LED chip comprising the plurality of target LED sub-units and the target substrate, wherein each of the target LED sub-units comprises the initial LED sub-unit and the first side wall reflective layer.

3. The manufacturing method according to claim 2, wherein a step of depositing the first target liquid onto the top surface of the first LED chip to form the target protective layer located on the top surface of the first LED chip, so as to obtain the second LED chip comprises:
mixing and stirring a first reagent and a second reagent at a predetermined ratio, to obtain an initial liquid;
removing air bubbles in the initial liquid to obtain the first target liquid; and
depositing the first target liquid onto the top surface of the first LED chip to form the target protective layer located on the top surface of the first LED chip, so as to obtain the second LED chip.

4. The manufacturing method according to claim 2, wherein the target protective layer comprises at least one of: a cleanable colloid, a polymer material, an adhesive tape of a predetermined type, an organic material that can be removed by solution, and an inorganic material that can be removed by solution.

5. The manufacturing method according to claim 2, wherein a step of treating the third LED chip according to the first target method to form reflective layers respectively wrapped around all surfaces except the bottom surfaces of the plurality of first LED sub-units, so as to obtain the fourth LED chip comprising the plurality of second LED sub-units and the target substrate comprises:
when the first target method is a solution deposition method, immersing the third LED chip in a second target liquid to form the reflective layers respectively wrapped around all surfaces except the bottom surfaces of the plurality of first LED sub-units, so as to obtain the fourth LED chip comprising the plurality of second LED sub-units and the target substrate.

6. The manufacturing method according to claim 2, wherein a step of treating the third LED chip according to the first target method to form reflective layers respectively wrapped around all surfaces except the bottom surfaces of the plurality of first LED sub-units, so as to obtain the fourth LED chip comprising the plurality of second LED sub-units and the target substrate comprises:
when the first target method is an evaporation method, performing vapor deposition on the third LED chip to form the reflective layers respectively wrapped around all surfaces except the bottom surfaces of the plurality of first LED sub-units, so as to obtain the fourth LED chip comprising the plurality of second LED sub-units and the target substrate.

7. The manufacturing method according to claim 2, wherein the reflective layer comprises at least one of: pure metal, semiconductor oxide, and ink.

8. The manufacturing method according to claim 2, wherein a step of removing the top reflective layers, the second side wall reflective layers and the first sub-protective layers of the plurality of second LED sub-units, to obtain the target LED chip comprising the plurality of target LED sub-units and the target substrate comprises:
determining a second target method according to a type of the first sub-protective layer; and
removing, by using the second target method, the top reflective layers, the second side wall reflective layers and the first sub-protective layers of the plurality of second LED sub-units, to obtain the target LED chip comprising the plurality of target LED sub-units and the target substrate.

9. The manufacturing method according to claim 8, wherein a step of removing, by using the second target method, the top reflective layers, the second side wall reflective layers and the first sub-protective layers of the plurality of second LED sub-units, to obtain the target LED chip comprising the plurality of target LED sub-units and the target substrate comprises:
In the case that the first sub-protective layers of the plurality of second LED sub-units cannot be removed by using the second target method, using a third target method to change shapes of the first sub-protective layers so as to obtain second sub-protective layers; and
removing, by using the second target method, the top reflective layers, the second side wall reflective layers and the second sub-protective layers of the plurality of second LED sub-units, to obtain the target LED chip comprising the plurality of target LED sub-units and the target substrate.

10. The manufacturing method according to any one of claims 2-9, wherein a step of etching the second LED chip from the target protective layer, and etching to the surface of the target substrate, so as to obtain the third LED chip comprising the plurality of first LED sub-units and the target substrate comprises:
etching the second LED chip by using an inductively coupled plasma etching method, and etching to the surface of the target substrate, so as to obtain the third LED chip comprising the plurality of first LED sub-units and the target substrate.
